# FASCICULE DE BREVET EUROPEEN

(11) **EP 3 531 138 B1**
(45) Date de publication et mention de la délivrance du brevet: **15.07.2020**
(21) Numéro de dépôt: 19158229.5
(22) Date de dépôt: 20.02.2019
(51) Int. Cl.: B60L 3/00, H04B 3/46, G01R 19/25, G01R 31/00

(54) **PROCÉDÉ D'ÉCHANGE DE DONNÉES DANS UN ÉQUIPEMENT ÉLECTRONIQUE, ÉQUIPEMENT ÉLECTRONIQUE, VÉHICULE FERROVIAIRE ET INSTALLATION FERROVIAIRE ASSOCIÉS**
DATENAUSTAUSCHVERFAHREN IN EINEM ELEKTRONISCHEN GERÄT, ENTSPRECHENDES ELEKTRONISCHES GERÄT, ENTSPRECHENDES SCHIENENFAHRZEUG UND ENTSPRECHENDE SCHIENENANLAGE
METHOD FOR EXCHANGING DATA IN AN ELECTRONIC DEVICE, ELECTRONIC DEVICE, ASSOCIATED RAILWAY VEHICLE AND RAILWAY INSTALLATION

(30) Priorité: 21.02.2018 FR 1851468
(43) Date de publication de la demande: 28.08.2019
(73) Titulaire: ALSTOM Transport Technologies, 93400 Saint-Ouen (FR)
(72) Inventeur: MELI, Takuefou, 65000 Tarbes (FR); RABASSE, Eric, 65310 Horgues (FR); CHAUCHAT, Bertrand, 65350 Lizos (FR); BONIN, Eric, 38200 Jardin (FR); LEPAGE, Jean-Pierre, 65460 Bours (FR); SCHILLING, Toby, 69003 Lyon (FR); FAUCON, Gérard, 69003 Lyon (FR)
(74) Mandataire: Lavoix

(56) Documents cités:
- US-A- 4 879 762
- US-A1- 2003 136 895

## Description

La présente invention concerne un procédé d'échange de données entre un module de puissance et une pluralité de commandes de grille de transistor. La présente invention se rapporte également à un équipement électronique, un véhicule ferroviaire et une installation ferroviaire associés.

Dans les installations ferroviaires, de nombreuses interactions sous forme de signaux ont lieu entre les différents éléments faisant partie de l'installation ferroviaire. Pour cela, les signaux transitent par un nombre élevé de réseaux et de câblage, de nature souvent différente.

Cela rend la maintenance des réseaux et des câblages compliquée pour assurer une bonne fiabilité de l'installation ferroviaire, en particulier pour ce qui concerne la sécurité de circulation des trains.

Il existe donc un besoin pour un procédé permettant l'échange de données dans au moins certaines parties d'une installation ferroviaire qui soit de mise en œuvre plus simple.

Un exemple de procédé d'échange de données entre un module de puissance et une pluralité de commandes de grille de transistor est divulgué dans US 2003/136895.

A cet effet, il est proposé un procédé d'échange de données entre un module de puissance et une pluralité de commandes de grille de transistor, chaque commande de grille contrôlant un transistor, chaque commande de grille étant reliée au module de puissance via une liaison optique, le procédé comportant des étapes de, pour au moins un transistor, mesure d'au moins une grandeur électrique relative au transistor, et de transmission de la mesure vers le module de puissance à travers la liaison optique.

Selon des modes de réalisation particuliers, le procédé présente une ou plusieurs des caractéristiques suivantes, prise(s) isolément ou selon toutes les combinaisons techniquement possibles :
- chaque transistor comporte un collecteur et un émetteur et dans lequel, pour chaque transistor, l'étape de mesure est mise en œuvre à l'aide d'un capteur électrique mesurant une grandeur électrique de la commande de grille du transistor ou le courant circulant dans l'émetteur ou le courant circulant dans le collecteur.
- le capteur électrique est un capteur de courant.
- le capteur électrique est un pont de Wheatstone.
- le pont de Wheatstone comporte quatre résistances, dont au moins une des résistances est une magnétorésistance.
- le transistor est relié à un lien électrique, le capteur électrique étant positionné sur le lien électrique.
- le capteur électrique est un capteur de tension.

Il est également proposé un équipement électronique comportant un module de puissance, une pluralité de transistors, une pluralité de commandes de grille, chaque commande de grille contrôlant un transistor respectif, et une liaison optique reliant le module de puissance à chaque commande de grille, au moins une grandeur électrique relative au transistor étant transmise à travers la liaison optique.

Il est aussi décrit véhicule ferroviaire comportant un système de traction comportant une pluralité d'équipements électroniques, au moins un équipement électronique étant tel que décrit précédemment.

Il est également proposé une installation ferroviaire comportant une pluralité d'équipements électroniques, au moins un équipement électronique étant tel que décrit précédemment.

La description propose également un procédé de contrôle d'équipements électroniques à l'aide d'un système de contrôle, le système de contrôle comportant un contrôleur central propre à contrôler chaque équipement électronique et un unique réseau optique passif reliant le contrôleur central à chaque équipement électronique, le procédé comprenant des étapes de multiplexage temporel d'un ensemble de données, au moins deux données étant relatives à deux équipements électroniques respectifs, pour obtenir un signal à transmettre, et d'échange des données entre chaque équipement électronique et le contrôleur central par transmission du signal à transmettre à travers le réseau optique passif.

Selon des modes de réalisation particuliers, le procédé de contrôle présente une ou plusieurs des caractéristiques suivantes, prise(s) isolément ou selon toutes les combinaisons techniquement possibles :
- l'étape de multiplexage temporel est appliquée sur un nombre de données égal au nombre d'équipements électroniques.
- chaque donnée est spécifique d'un équipement électronique respectif.
- des données sont une commande d'un équipement électronique.
- des données sont une mesure électrique relative à un équipement électronique.
- le contrôleur central est une unité de contrôle d'un système de traction d'un véhicule ferroviaire.
- chaque équipement électronique est un module de puissance propre à alimenter une pluralité de transistors.

Il est également proposé un système de contrôle d'équipements électroniques, le système de contrôle comportant un contrôleur central propre à contrôler chaque équipement électronique, un unique réseau optique passif reliant le contrôleur central à chaque équipement électronique, le système de contrôle étant propre à mettre en œuvre un procédé de contrôle des équipements électroniques, le procédé comprenant des étapes de multiplexage temporel d'un ensemble de données, au moins deux données étant relatives à deux équipements électroniques respectifs, pour obtenir un signal à transmettre, et d'échange des données entre chaque équipement électronique et le contrôleur central par transmission du signal à transmettre à travers le réseau optique passif.

Il est aussi décrit un véhicule ferroviaire comportant un système de traction comportant une pluralité d'équipements électroniques et un système de contrôle d'équipements électroniques tel que décrit précédemment.

Il est également proposé une installation ferroviaire comportant une pluralité d'équipements électroniques et un système de contrôle d'équipements électroniques tel que décrit précédemment.

Des caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'une partie d'une installation ferroviaire comportant des équipements électroniques, et
- la figure 2 est une représentation schématique d'un équipement électronique. Une partie d'une installation ferroviaire est représentée sur la figure 1.

Une installation ferroviaire est une installation dans laquelle circule des véhicules ferroviaires.

Un véhicule ferroviaire est, par exemple, un métro équipé d'une ventilation de secours, un train ou un tramway.

L'installation ferroviaire comporte un système de contrôle 12 et un ensemble d'équipements électroniques 14.

Dans l'exemple décrit, le système de contrôle 12 et l'ensemble d'équipements électroniques 14 est le système de traction d'un véhicule ferroviaire.

Le système de contrôle 12 comporte un contrôleur central 16 et un réseau optique passif 18.

Le contrôleur central 16 est propre à contrôler chaque équipement électronique 14.

Selon l'exemple décrit, le contrôleur central 16 est une unité de contrôle d'un système de traction d'un véhicule ferroviaire.

Le réseau optique passif 18 est également désigné sous l'acronyme PON qui renvoie à la terminologie anglaise de « Passive Optical Network ».

Le réseau optique passif 18 relie le contrôleur central 16 à chaque équipement électronique 14.

Chaque équipement électronique 14 est un équipement de haute tension. Par une telle expression, il est entendu que chaque équipement électronique 14 est destiné à être alimenté en haute tension, c'est-à-dire typiquement une tension continue d'une valeur nominale supérieure ou égale à 600 Vdc. Par exemple, dans l'exemple représenté, la tension d'alimentation de chaque équipement électronique 14 est égale à 1500 Vdc.

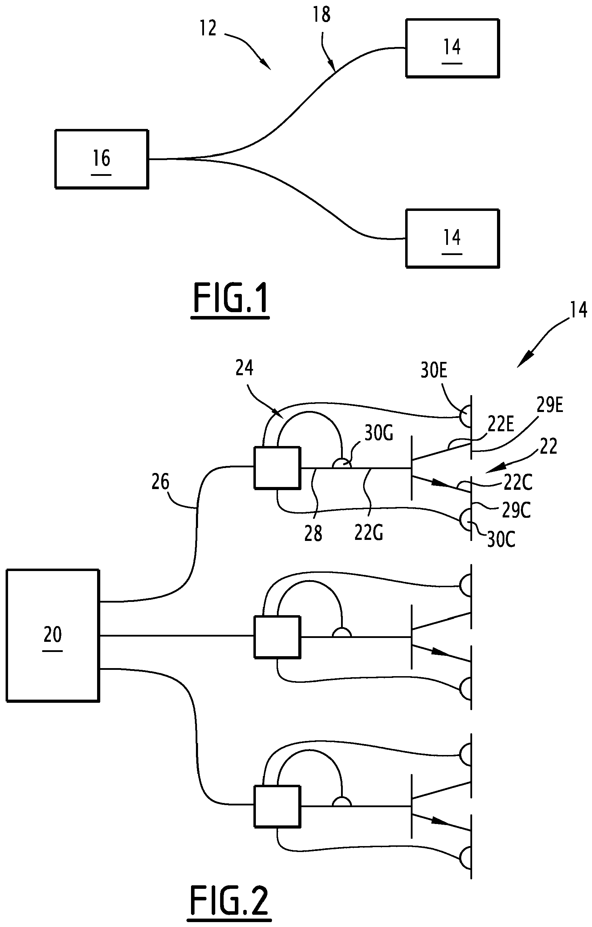

Un exemple d'équipement électronique 14 est visible sur la figure 2. Dans un tel exemple, chaque équipement électronique 14 est un allumeur.

L'allumeur comporte un module de puissance 20, une pluralité de transistors 22, une pluralité de commandes de grille 24 et une liaison optique 26.

Le module de puissance 20 est souvent désigné sous le terme anglais de « power module ».

Le module de puissance 20 est propre à alimenter chaque transistor 22.

Chaque transistor 22 est, par exemple, un transistor bipolaire à grille isolée (aussi désigné par l'acronyme IGBT renvoyant au terme anglais d' « Insulated Gâte Bipolar Transistor »).

Dans un tel cas, le transistor 22 est un composant comportant trois bornes appelées la grille 22G (aussi désignée par le terme « gate » en anglais), le collecteur 22C et l'émetteur 22E.

En outre, le transistor 22 est porté à des tensions très élevées pouvant atteindre plusieurs milliers de volts.

Le transistor 22 est commandé par un lien électrique 28, le transistor 22 étant relié au niveau de la grille 22G à la commande de grille 24.

Le transistor 22 est relié électriquement au reste du circuit par les liens électriques 29E et 29C, aussi appelés broches 29E et 29C. Au moins un des broches est un busbar.

Chaque commande de grille 24 est désignée sous le terme anglais de « gate driver ».

Chaque commande de grille 24 est propre à contrôler un transistor 22 respectif.

Chaque commande de grille 24 est pourvue d'au moins un capteur électrique 30G, 30C ou 30E, désigné généralement sous le signe de référence 30 lorsqu'il s'agit d'un des trois capteurs précédents, mesurant une grandeur électrique de la commande de grille 24 du transistor 22.

Par exemple, les mesures sont la variation de la tension en fonction du temps ou la variation du rapport entre la tension entre la grille 22G et l'émetteur 22E et la tension entre le collecteur 22C et la grille 22G.

En variante, le capteur électrique 30 permet de mesurer le courant circulant à travers le collecteur 22C (via la broche 29C) et l'émetteur 22E (via la broche 29E).

Dans l'exemple représenté, le capteur électrique 30C est un capteur de courant.

Le capteur électrique 30C est un pont de Wheastone dont une des résistances est une magnétorésistance. Le pont de Wheastone est apte à mesurer une variation de champ magnétique par mesure du déséquilibre dans la tension du point de résistance puisque la magnétorésistance est sensible aux variations de champ magnétique.

Le capteur électrique 30C est positionné sur la broche 29C. Le capteur électrique 30C mesure ainsi directement le courant transistant à travers la broche 29C reliée au collecteur 22C du transistor 22.

En variante, le capteur électrique 30C est un capteur de tension.

Des caractéristiques analogues s'appliquent aux capteurs électriques 30G et 30E.

La liaison optique 26 relie le module de puissance 20 à chaque commande de grille 24.

Au moins une grandeur électrique relative au transistor 22 est transmise par la liaison optique 26.

Le fonctionnement du système de contrôle 12 est maintenant décrit en référence à un exemple de mise en œuvre d'un procédé de contrôle.

Le procédé de contrôle est un procédé de contrôle des équipements électroniques 14 à l'aide du système de contrôle 12.

Le procédé comporte une étape de multiplexage et une étape d'échange.

Lors de l'étape de multiplexage, il est mis en œuvre un multiplexage temporel d'un ensemble de données.

Au moins deux données sont relatives à deux équipements électroniques 14 respectifs.

A titre d'illustration, dans le cas proposé, l'ensemble de données comporte au moins une donnée relative à chaque équipement électronique 14.

Par exemple, chaque donnée est une donnée mesurée par un équipement électronique 14 respectif via les capteurs électriques 30.

L'étape de multiplexage permet de transmettre l'ensemble des données mesurées par les différents équipements 14 au contrôleur central 16 et que le contrôleur 16 identifie leur provenance.

Avantageusement, l'étape de multiplexage temporel est appliquée sur un nombre de données égal au nombre d'équipements électroniques 14. Cela signifie que nombre de canaux temporels est égal au nombre d'équipements électroniques 14. De préférence, chaque canal temporel est spécifique à un équipement électronique 14.

Lors de l'étape d'échange, il est transmis le signal à transmettre depuis chaque équipement électronique 14 vers le contrôleur central 16. La transmission a lieu à travers le réseau optique passif 18.

Le procédé de contrôle proposé permet ainsi d'illustrer comment chaque équipement électronique 14 transmet des données et notamment des données mesurées au contrôleur central 16.

Le principe est ainsi celui du partage du temps de parole, aussi appelé sous la terminologie anglaise de « time-sharing ».

Ce procédé permet ainsi de communiquer des mesures électriques relatives à un équipement électronique 14, c'est-à-dire des données mesurées, au contrôleur central 16.

Le signal à transmettre est transmis depuis chaque équipement électronique 14 vers le contrôleur central 16 suivant le multiplexage temporel déterminé, c'est-à-dire suivant l'ordre temporel déterminé.

Dans le sens contrôleur central 16 vers équipements 14 des ordres de commande ou commandes sont transmis aux équipements 14 par intégration dans un message groupé envoyé à tous les équipements 14. Chaque équipement 14 ne traite que la partie du message qui le concerne.

Il est à noter que l'utilisation du multiplexage temporel procure des avantages par rapport à l'emploi du multiplexage en fréquence notamment en termes de robustesse notamment vis-à-vis des interférences éventuelles et de facilité de mise en œuvre.

En variante, les ordres de commande sont transmis sous forme de paquets de messages ayant un identifiant unique propre à chaque équipement.

Selon une autre variante, un procédé de contrôle similaire à celui présenté ci-dessus pour la communication depuis le contrôleur central 16 vers les équipements 14 est utilisé.

A titre d'exemple, chaque donnée mesurée est obtenue par mise en œuvre d'un procédé d'échange de données.

Le procédé d'échange de données est un procédé d'échanges de données entre le module de puissance 20 et les commandes de grille de transistor 22.

Le procédé d'échange comporte une étape de mesure et une étape de transmission.

Dans l'exemple décrit, l'étape de mesure est mise en œuvre pour chaque transistor 22 par une mesure de courant effectué par chaque capteur électrique 30.

A l'issue de l'étape de mesure, il est obtenu un ensemble de mesure de courant.

Lors de l'étape de transmission, il est transmis chaque mesure vers le module de puissance 20 à travers la liaison optique 26.

Comme expliqué précédemment, chaque mesure est multiplexée temporellement puis transmise au contrôleur central 16.

L'utilisation d'un réseau optique permet de manière générale dans une communication entre deux équipements de procurer une robustesse et une rapidité améliorées.

L'utilisation d'un seul réseau optique passif 18 rend ainsi possible un fonctionnement de commande distribuée. Cela permet que d'une part l'ensemble des ordres de commutation circule entre le contrôleur central 16 et les équipements électroniques 14 et d'autre part, que les informations relatives au composant des équipements électroniques 14 soient transmises au contrôleur central 16.

Ainsi, le nombre de connexions entre le contrôleur central 16 et les équipements électroniques 14 est réduit. Ceci implique également une meilleure compatibilité électromagnétique.

De plus, le réseau optique passif 18 assure une isolation galvanique de bonne qualité entre le contrôleur central 16 et chacun des équipements électroniques 14.

De plus, l'utilisation du réseau optique passif 18 est meilleure que l'utilisation d'une couche physique à base de fibre optique pour faire circuler les informations de commande. En effet, dans le cas d'une couche physique à base de fibre optique, les données mesurées par différents équipements peuvent être transmises simultanément, ce qui complique le traitement au niveau du contrôleur 16.

L'utilisation du réseau optique passif 18 améliore la fiabilité du contrôle sans complexifier le montage.

De plus, un réseau optique passif 18 est peu onéreux.

En outre, le principe du partage du temps de parole continu permet une transmission continue des mesures, ce qui rend possible une commande entièrement centralisée.

Une commande centralisée permet de faciliter l'emploi de stratégie de redondance et de limiter la consommation.

Il est à noter que la commande centralisée peut être mise en place pour un nombre quelconque d'équipements et qu'il n'y a pas de contraintes sur le positionnement des équipements, la longueur du réseau optique passif 18 n'étant pas imposée.

Les effets précités sont encore renforcés par l'emploi d'une liaison point à point entre chaque commande de grille 24 et le module de puissance 20 associée. Cela permet notamment d'éviter d'utiliser une isolation galvanique au niveau de chaque capteur électrique 30 en profitant de l'isolation galvanique présente au niveau du module de puissance 20.

En résumé, il est ainsi obtenu un procédé permettant l'échange de données dans au moins certaines parties d'une installation ferroviaire qui soit de mise en œuvre plus simple.

## Revendications

1. Procédé d'échange de données entre un module de puissance (20) et une pluralité de commandes de grille (24) de transistor (22), chaque commande de grille (24) contrôlant un transistor (22), chaque commande de grille (24) étant reliée au module de puissance (20) via une liaison optique (26), le procédé comportant une étape de :
- pour au moins un transistor (22), mesure d'au moins une grandeur électrique relative au transistor (22),
le procédé étant **caractérisé en ce qu'**il comporte une étape de :
- transmission de la mesure vers le module de puissance (20) à travers la liaison optique (26).

2. Procédé selon la revendication 1, dans lequel, chaque transistor (22) comporte un collecteur (22C) et un émetteur (22E) et dans lequel, pour chaque transistor (22), l'étape de mesure est mise en œuvre à l'aide d'un capteur électrique (30C, 30G, 30E) mesurant une grandeur électrique de la commande de grille (24) du transistor (22) ou le courant circulant dans l'émetteur (22E) ou le courant circulant dans le collecteur (22C).

3. Procédé selon la revendication 2, dans lequel le capteur électrique (30C, 30G, 30E) est un capteur de courant.

4. Procédé selon la revendication 2 ou 3, dans lequel le capteur électrique (30C, 30G, 20E) est un pont de Wheatstone.

5. Procédé selon la revendication 4, dans lequel le pont de Wheatstone comporte quatre résistances, dont au moins une des résistances est une magnétorésistance.

6. Procédé selon l'une quelconque des revendications 2 à 6, dans lequel le transistor (22) est relié à un lien électrique (28, 29C, 29E), le capteur électrique (30C, 30G, 30E) étant positionné sur le lien électrique (28, 29C, 29E).

7. Procédé selon la revendication 2, dans lequel le capteur électrique (30C, 30G, 30E) est un capteur de tension.

8. Equipement électronique (14) comportant :
- un module de puissance (20),
- une pluralité de transistors (22),
- une pluralité de commandes de grille (24), chaque commande de grille (24) contrôlant un transistor (22) respectif,
- au moins un organe de mesure d'au moins une grandeur électrique relative à l'un des transistors (22), et **caractérisé en ce qu'**il comporte :
- une liaison optique (26) reliant le module de puissance (20) à chaque commande de grille (24), la au moins une grandeur électrique mesurée par l'organe de mesure étant transmise à travers la liaison optique (26).

9. Véhicule ferroviaire comportant un système de traction comportant une pluralité d'équipements électroniques (14), au moins un équipement électronique (14) étant selon la revendication 8.

10. Installation ferroviaire comportant une pluralité d'équipements électroniques (14), au moins un équipement électronique (14) étant selon la revendication 8.

## Patentansprüche

1. Verfahren zum Datenaustausch zwischen einem Leistungsmodul (20) und einer Mehrzahl von Transistor (22)-Gate-Steuerungen (24), wobei jede Gate-Steuerung (24) einen Transistor (22) steuert und jede Gate-Steuerung (24) mit dem Leistungsmodul (20) über eine optische Verbindung (26) verbunden ist, wobei das Verfahren aufweist:
- für mindestens einen Transistor (22) einen Schritt des Messens mindestens einer elektrischen Größe bezüglich des Transistors (22),
wobei das Verfahren **dadurch gekennzeichnet ist, dass** es aufweist:
- einen Schritt des Übertragens der Messung an das Leistungsmodul (20) über die optische Verbindung (26).

2. Verfahren nach Anspruch 1, bei dem jeder Transistor (22) einen Kollektor (22C) und einen Emitter (22E) aufweist und bei dem für jeden Transistor (22) der Schritt des Messens mithilfe eines elektrischen Sensors (30C, 30G, 30E) durchgeführt wird, der eine elektrische Größe der Gate-Steuerung (24) des Transistors (22) oder den im Emitter (22E) fließenden Strom oder den im Kollektor (22C) fließenden Strom misst.

3. Verfahren nach Anspruch 2, bei dem der elektrische Sensor (30C, 30G, 30E) ein Stromsensor ist.

4. Verfahren nach Anspruch 2 oder 3, bei dem der elektrische Sensor (30C, 30G, 30E) eine Wheatstone-Brücke ist.

5. Verfahren nach Anspruch 4, bei dem die Wheatstone-Brücke vier Widerstände aufweist, von denen mindestens ein Widerstand ein Magnetowiderstand ist.

6. Verfahren nach einem beliebigen der Ansprüche 2 bis 6, bei dem der Transistor (22) an eine elektrische Leitung (28, 29C, 29E) angeschlossen ist, wobei der elektrische Sensor (30C, 30G, 30E) in der elektrischen Leitung (28, 29C, 29E) liegt.

7. Verfahren nach Anspruch 2, bei dem der elektrische Sensor (30C, 30G, 30E) ein Spannungssensor ist.

8. Elektronische Einrichtung (14), umfassend:
- ein Leistungsmodul (20),
- eine Mehrzahl von Transistoren (22),
- eine Mehrzahl von Gate-Steuerungen (24), wobei jede Gate-Steuerung (24) einen jeweiligen Transistor (22) steuert,
- mindestens ein Messelement für mindestens eine elektrische Größe bezüglich eines der Transistoren (22) und **dadurch gekennzeichnet, dass** sie umfasst:
- eine optische Verbindung (26), die das Leistungsmodul (20) mit jeder Gate-Steuerung (24) verbindet, wobei die mindestens eine elektrische Größe, die von dem Messelement gemessen wird, über die optische Verbindung (26) übertragen wird.

9. Schienenfahrzeug, das ein eine Mehrzahl von elektronischen Einrichtungen (14) aufweisendes Zugsystem aufweist, wobei mindestens eine elektronische Einrichtung (14) nach Anspruch 8 ausgebildet ist.

10. Bahnanlage, die eine Mehrzahl von elektronischen Einrichtungen (14) aufweist, wobei mindestens eine elektronische Einrichtung (14) nach Anspruch 8 ausgebildet ist.

## Claims

1. Method for exchanging data between a power module (20) and a plurality of transistor (22) gate drivers (24), each gate driver (24) controlling a transistor (22), each gate driver (24) being connected to the power module (20) *via* an optical link (26), the method comprising a step of:
- for at least one transistor (22), measuring at least one electrical quantity relating to the transistor (22),
the method being **characterised in that** it comprises a step of:
- transmitting the measurement to the power module (20) through the optical link (26).

2. Method according to claim 1, wherein each transistor (22) comprises a collector (22C) and an emitter (22E) and wherein, for each transistor (22), the measuring step is carried out with the aid of an electrical sensor (30C, 30G, 30E) which measures an electrical quantity of the gate driver (24) of the transistor (22) or the current flowing through the emitter (22E) or the current flowing through the collector (22C).

3. Method according to claim 2, wherein the electrical sensor (30C, 30G, 30E) is a current sensor.

4. Method according to claim 2 or 3, wherein the electrical sensor (30C, 30G, 20E) is a Wheatstone bridge.

5. Method according to claim 4, wherein the Wheatstone bridge comprises four resistors, of which at least one of the resistors is a magnetoresistor.

6. Method according to any one of claims 2 to 6, wherein the transistor (22) is connected to an electrical link (28, 29C, 29E), the electrical sensor (30C, 30G, 30E) being positioned on the electrical link (28, 29C, 29E).

7. Method according to claim 2, wherein the electrical sensor (30C, 30G, 30E) is a voltage sensor.

8. Piece of electronic equipment (14) comprising:
- a power module (20),
- a plurality of transistors (22),
- a plurality of gate drivers (24), each gate driver (24) controlling a respective transistor (22),
- at least one measuring member for measuring at least one electrical quantity relating to one of the transistors (22), and **characterised in that** it comprises:
- an optical link (26) connecting the power module (20) to each gate driver (24), the at least one electrical quantity measured by the measuring member being transmitted through the optical link (26).

9. Railway vehicle comprising a traction system comprising a plurality of pieces of electronic equipment (14), at least one piece of electronic equipment (14) being in accordance with claim 8.

10. Railway installation comprising a plurality of pieces of electronic equipment (14), at least one piece of electronic equipment (14) being in accordance with claim 8.
